## Europäisches Patentamt
## European Patent Office
## Office européen des brevets

(19)

(11) Numéro de publication: **0 032 764 B1**

(12)

# FASCICULE DE BREVET EUROPEEN

(45) Date de publication du fascicule du brevet:
**02.11.83**

(51) Int. Cl.³: **H 05 K 13/04,** H 05 K 13/02, H 05 K 3/30

(21) Numéro de dépôt: **81200022.2**

(22) Date de dépôt: **12.01.81**

(54) **Procédé et dispositif d'assemblage simultané de composants sur un support.**

(30) Priorité: **21.01.80 FR 8001216**

(43) Date de publication de la demande:
**29.07.81 Bulletin 81/30**

(45) Mention de la délivrance du brevet:
**02.11.83 Bulletin 83/44**

(84) Etats contractants désignés:
**CH DE FR GB IT LI**

(56) Documents cités:
**DE - A - 2 164 865**
**DE - A - 2 716 330**
**US - A - 3 961 911**

(73) Titulaire: **R.T.C. LA RADIOTECHNIQUE-COMPELEC Société anonyme dite:, 51 rue Carnot BP 301, F-92156 Suresnes (FR)**

(84) Etats contractants désignés: **FR**

(73) Titulaire: **N.V. Philips' Gloeilampenfabrieken, Groenewoudseweg 1, NL-5621 BA Eindhoven (NL)**

(84) Etats contractants désignés: **CH DE GB IT LI**

(72) Inventeur: **Sorel, Alain, Société Civile S.P.I.D. 209 Rue de l'Université, F-75007 Paris (FR)**
Inventeur: **Bury, Michel, Société Civile S.P.I.D. 209 Rue de l'Université, F-75007 Paris (FR)**

(74) Mandataire: **Pinchon, Pierre et al, Société Civile S.P.I.D. 209 rue de L'Université, F-75007 Paris (FR)**

ACTORUM AG

Procédé et dispositif d'assemblage simultané de composants sur un support

La présente invention concerne un procédé d'assemblage d'une pluralité de composants électroniques sur une face d'un support muni de métallisations, procédé dans lequel on utilise des chargeurs tubulaires pourvus d'un orifice supérieur et d'un orifice inférieur renfermant chacun une pile de composants, chargeurs disposés selon une configuration identique à celle désirée pour les composants sur le support et dans lequel, à la suite du positionnement des métallisations dudit support en correspondance avec les orifices supérieurs des chargeurs, on fait monter les composants de chaque chargeur de telle façon que le composant du haut arrive en butée contre le support.

L'invention concerne également un dispositif pour la mise en œuvre du procédé ci-dessus, dispositif comportant des chargeurs tubulaires contenant chacun une pile de composants soutenus par un élément coulissant.

On sait que les composants pour circuits électroniques se ramènent en général à deux types: ceux que l'on fixe à plat sur un support non percé, et ceux qui ont des conducteurs électriques destinés à passer dans des trous du support.

La présente invention concerne le montage de composants du premier type. Elle s'applique essentiellement au montage des composants sur des supports dits «substrats» de façon à constituer des circuits dits «hybrides». Les machines d'assemblage pour les circuits hybrides que l'on peut acheter dans le commerce mettent en œuvre des robots qui prennent les composants dans un chargeur et les positionnent sur le support, ou substrat, en fonction d'une programmation et au moyen d'une mécanique plus ou moins compliquées. Le processus est séquentiel, c'est-à-dire que les composants sont montés les uns après les autres, soit successivement par le même robot, soit au moyen de postes successifs sur un tapis roulant. Ces machines ont l'inconvénient d'être chères, compliquées à programmer et relativement lentes à cause du processus séquentiel.

Un autre procédé de montage est connu du brevet américain US 4 127 432. Il consiste à utiliser des chargeurs tubulaires verticaux dans lequels on pousse vers le haut des piles de composants à l'aide de tiges mues vers le haut par l'intermédiaire de ressorts. Ces tiges sont disposées de façon permanente selon une configuration déterminée, de préférence selon un réseau régulier. Ceci impose que les composants soient disposés, eux aussi, selon une grille ayant le même pas que le réseau des tiges. Par ailleurs, la section des chargeurs ne peut être supérieure au pas du réseau. On a donc cet inconvénient que, si on choisit un pas important, on aura beaucoup de surface inoccupée puisqu'on ne pourra pas placer de composants ailleurs que sur les positions déterminées par la grille et que, si l'on choisit un pas réduit, certains composants ne pourront pas être montés puisqu'on ne pourra pas monter de composants de taille supérieure au pas de la grille. De plus, les ressorts exercent le même effort, quelques soit le poids des composants, ce qui est désavantageux.

La présente invention a pour but de remédier à tous les inconvénients ci-dessus. Elle est basée sur l'idée de pousser les composants à l'aide d'air comprimé.

En effet, selon l'invention, un procédé d'assemblage simultané de composants sur un support est remarquable en ce qu'on réunit l'orifice inférieur de chaque chargeur tubulaire à une source de fluide et qu'on réalise la montée des composants au moyen d'une surpression dudit fluide. Ceci présente l'avantage essentiel qu'on peut placer les chargeurs selon toute configuration désirée sans être obligé de suivre un réseau régulier, et qu'on profite donc au mieux de la place disponible sur les substrats tout en étant capable de monter des composants de n'importe quelle dimension. De plus, la force appliquée est d'autant plus grande que la surface du composant est grande, donc que le composant est plus lourd, en général.

Un procédé selon l'invention est également remarquable en ce qu'on applique simultanément la surpression à tous les chargeurs tubulaires, ce qui permet de gagner du temps.

Un dispositif selon l'invention est notamment remarquable en ce qu'il comporte également un capot étanche alimenté en gaz comprimé, capot dans lequel débouchent les orifices inférieurs des chargeurs.

Cette disposition permet de relier globalement et très facilement l'orifice inférieur de chaque chargeur à la source de fluide. Avantageusement, des chargeurs selon l'invention possèdent des parois très minces dont la section transversale épouse la forme des composants que le chargeur contient. L'avantage de parois très minces pour les tubes chargeurs est que cela permet de placer lesdits tubes côte à côte en perdant très peu de place et que, de ce fait, on peut avoir autant de tubes que de composants à mettre en place et donc positionner en une seule opération tous les composants selon une configuration dont la densité n'est pas limitée par le dispositif, ce qui gagne beaucoup de temps.

Dans une forme de réalisation particulière, un dispositif selon l'invention comporte une platine supérieure qui constitue le couvercle du capot étanche, qui est percée de trous disposés selon une configuration identique à celle désirée pour les composants sur le support, trous au travers desquels débouchent les orifices supérieurs des chargeurs contenus dans le capot, et qui est pourvue de moyens pour positionner les métallisations du support en correspondance avec les orifices supérieurs des chargeurs.

Cette disposition permet de réaliser très simplement toutes les fonctions nécessaires pour la mise en œuvre du procédé.

Dans une autre forme de réalisation, un dispositif selon l'invention est remarquable en ce que le capot étanche est surmonté par un bloc de matériau élastomère qui constitue le courvecle du capot, maintient les chargeurs disposés selon une configuration identique à celle désirée pour les composants sur le support, et est pourvu de moyens pour positionner les métallisations du support en correspondance avec les orifices supérieurs des chargeurs.

Cette forme de réalisation permet d'utiliser un capot de petite taille, et donc d'avoir un volume de gaz plus faible et une surpression mieux contrôlée.

La description qui va suivre, en regard des dessins annexés, décrivant un mode de réalisation non limitatif, fera bien comprendre comment l'invention peut être réalisée.

La figure 1 représente un dispositif selon l'invention, vu de dessus.

La figure 2 représente une coupe selon 1.1 du dispositif représenté en figure 1.

La figure 3 représente une vue en perspective d'un chargeur tubulaire.

La figure 4 représente la coupe selon II-II du chargeur représenté par la figure 3.

La figure 5 représente la coupe d'une autre forme de réalisation d'un dispositif selon l'invention.

La figure 6 représente une vue agrandie d'un détail de la figure 5.

La figure 7 représente une vue en perspective d'un chargeur tubulaire particulier.

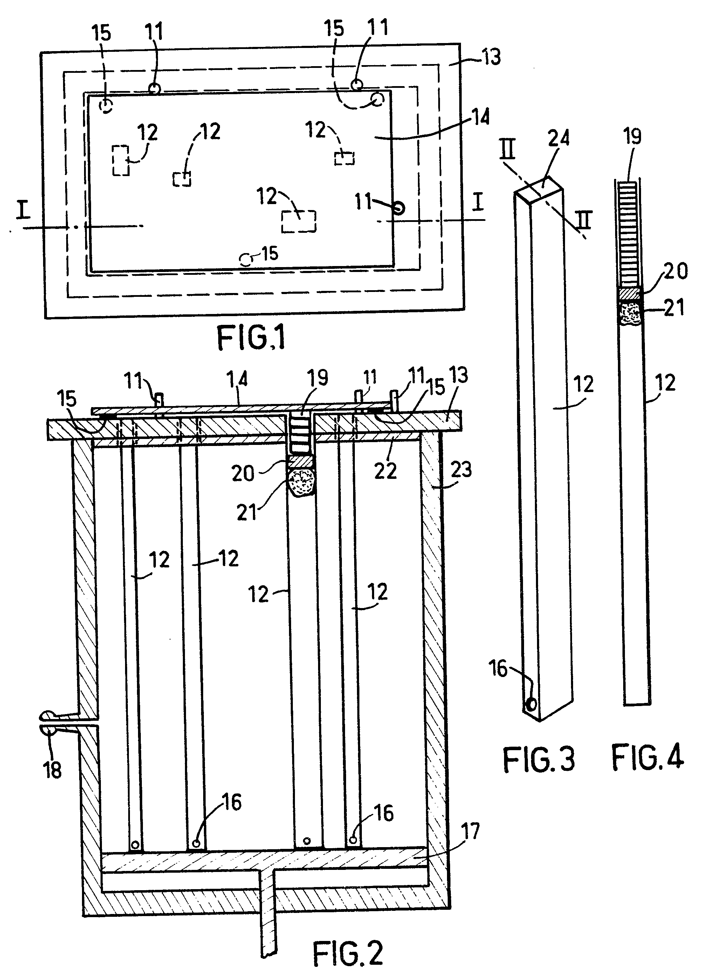

Conformément aux figures 1, 2 et 3, dans un procédé d'assemblage d'une pluralité de composants électroniques 19 sur une face d'un support 14 appelée également substrat et muni de métallisations, on utilise des chargeurs tubulaires 12 pourvus chacun d'un orifice supérieur 24 et d'un orifice inférieur 16 et renfermant chacun une pile de composants 19, chargeurs disposés selon une configuration identique à celle désirée pour les composants sur le support. Cette configuration est appelée, en général, implantation. On place ensuite le substrat 14, métallisations en-dessous, contre les cales 15 et les butées 11 que l'on a disposées de façon à ce que les métallisations prévues sur le substrat pour souder les composants se trouvent en face des orifices supérieurs des chargeurs correspondants. Ensuite, on fait monter les composants 19 de chaque chargeur de telle façon que le composant 19 du haut arrive en butée contre le support 14. Pour ce faire, on a réuni l'orifice inférieur 16 de chaque chargeur tubulaire 12 à une source de fluide et on réalise la montée des composants 19 au moyen d'une surpression dudit fluide, surpression appliquée simultanément à tous les chargeurs tubulaires 12.

Les métallisations du support 14 placées en-dessous ont été préalablement enduites, par exemple par sérigraphie, aux emplacements où une connexion électrique est prévue, d'une pâte à souder par refusion, pâte dont la propriété incidente d'être gluante permet de retenir les composants 19 appliqués selon la susdite configuration contre le support 14 lorsque l'on cesse ensuite de pousser la pile de composants 19 vers le haut. On pourra alors soulever le support 14 qui emmènera avec lui un composant 19 par chargeur 12, composant retenu chacun à sa place par la pâte à souder. Ce support sera alors retourné de façon à avoir les métallisations — et les composants — au-dessus, et acheminé vers un poste de refusion de la pâte à souder.

Le dispositif des figures 1 et 2 comporte des chargeurs tubulaires 12, représentés plus en détail sur les figures 3 et 4, et contenant chacun une pile de composants 19 soutenus par un élément coulissant 20, 21 qui maintient la pile de composants, après suppression de la surpression du fluide, grâce à son frottement sur les parois du chargeur. Cet élément est constitué par exemple d'un bloc de polystyrène expansé 20 associé à une bourre textile 21.

Le dispositif comporte également un capot étanche 23 alimenté en gaz comprimé par un tuyau 18, capot dans lequel débouchent les orifices inférieurs 16 des chargeurs. Ceux-ci possèdent des parois très minces dont la section transversale épouse la forme des composants que le chargeur contient.

Ce dispositif comporte enfin une platine supérieure 13 qui constitue le couvercle du capot étanche 23 qui est percée de trous disposés selon une configuration identique à celle désirée pour les composants sur le support, trous au travers desquels débouchent les orifices supérieurs 24 des chargeurs contenus dans le capot 23, et qui est pourvue de moyens constitués par des ergots 11 et des cales d'épaisseur 15 pour positionner les métallisations du support en correspondance avec les orifices supérieurs des chargeurs.

Les cales 15 servent à éviter de salir la plaque 13 avec la pâte à souder qui a été préalablement déposée sur les supports 14, en écartant ceux-ci de la platine 13 d'une distance égale à environ le tiers de la hauteur du composant le plus mince.

Les ergots 11 permettent le positionnement horizontal du support 14 qui est pressé vers le bas, par exemple à la main.

Lors de la préparation du dispositif, les tubes chargeurs 12 sont enfilés vers le bas à frottement doux dans les trous de la platine 13 jusqu'à ce qu'ils reposent par leur extrémité inférieure sur un plateau 17 qui les soutient de façon telle que leur orifice supérieur affleure au-dessus de la platine 13. Un joint 22 assure l'étanchéité entre les tubes chargeurs et la platine. Il peut être réalisé en coulant dans le dispositif placé la tête en bas une petite quantité de résine élastomère qui, après polymérisation, est à la fois élastique et peu adhésive.

Le plateau 17, en coulissant dans le capot 23, permet d'extraire les chargeurs 12 au travers de la platine 13 lorsque lesdits chargeurs, ou l'un d'entre eux, sont vides et ont besoin d'être regarnis en composants. Le garnissage se fait sur un poste de travail séparé, muni par exemple d'un bol vibrant et de goulottes appropriées. L'usage d'un joint 22 élastomère silicone plutôt qu'un collage ou une soudure permet le coulissement des chargeurs 12 au travers des trous de la platine 13.

Ainsi, on aura un type de platine 13 par modèle de circuit à fabriquer et un type de chargeur 12 par modèle de composant à utiliser, quelque soit le circuit auquel ledit composant est destiné. Les mêmes chargeurs pourront être montés, selon les besoins, dans différentes platines.

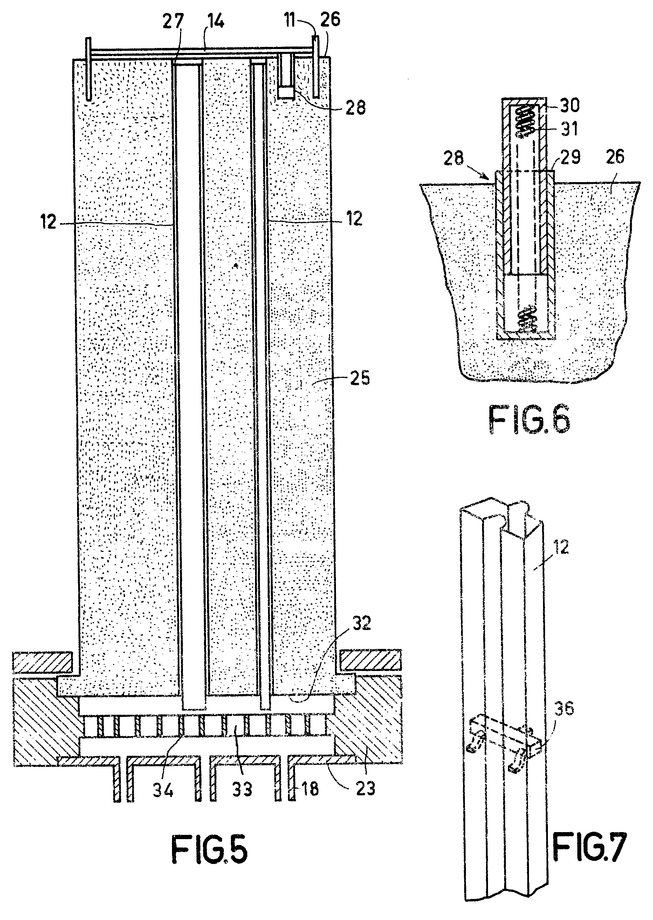

La figure 5 représente un autre mode de réalisation d'un dispositif selon l'invention, dans lequel le capot étanche 23 est surmonté par un bloc de matériau élastomère 25 qui constitue le couvercle du capot, maintient les chargeurs 12 disposés selon une configuration identique à celle désirée pour les composants sur le support, et est pourvu de moyens 11, 28 pour positionner les métallisations du support en correspondance avec les orifices supérieurs des chargeurs.

On aura donc, pour chaque modèle de circuit à réaliser, un modèle de bloc en matériau élastomère contenant des chargeurs. Ces blocs sont très rapidement amovibles lorsqu'on change de type de circuit. Par contre, les chargeurs sont délicats à extraire et il vaut mieux les remplir sans les sortir du bloc. Pour faciliter cette opération, leur extrémité supérieure 27 arrive légèrement en-dessous de la face supérieure du bloc élastomère. Ceci permet d'enfoncer l'extrémité inférieure d'un tube (non représenté) plein de composants, tube identique à celui qui est moulé dans le bloc, et de le positionner pour ensuite pousser les composants du tube plein dans le tube vide. Les tubes 12 sont simplement coupés dans un tube de grande longueur et donc n'ont pas de fond. Le trou 16 de la figure 3 est inutile puisqu'il n'y a pas de piston 17 venant boucher le bas des tubes.

Pour réaliser ce bloc élastomère, on fabrique un moule (non représenté). Les faces du moule correspondant à la face supérieure 26 et à la face inférieure 32 du bloc 25 à mouler portent, dans les positions appropriées, des tétons de section adaptée à la section intérieure des tubes à positionner, et qui s'enfoncent dans ces tubes pour les maintenir en position lors du moulage. L'une des faces porte aussi des tiges pour ménager des trous borgnes dans lesquels seront enfoncés les ergots 11 et des canons à ressort 28. Bien entendu, seules ces faces des moules sont spécifiques d'un modèle de substrat à garnir de composants, le reste de l'outillage étant universel.

Le capot 23 comporte à l'intérieur une paroi 34 percée de trous 33 très rapprochés et constituant une sorte de plaque en nid d'abeilles. Cette plaque sert à canaliser l'air comprimé pour obtenir un flux de filets d'air sensiblement parallèles pénétrant mieux dans les tubes. L'air est amené par une pluralité de tubes 18 de façon à répartir le plus régulièrement possible la poussée qui est réalisée au moyen d'impulsions de pression brèves.

La figure 6 montre un canon à ressort 28. Il est constitué de deux cylindres coulissant téléscopiquement l'un dans l'autre et se repoussant grâce à un ressort 31. Ils sont placés dans la face supérieure du bloc 25 en des positions correspondant à des endroits uinutilisés du support 14.

Le cylindre extérieur 29 pris dans le matériau élastomère est donc fixe. Le cylindre intérieur 30 mobile constitue une pièce mue par une force élastique vers une position haute et aide à soulever le support lorsque l'opération d'assemblage global des composants sur le support est terminée. Le cylindre extérieur fixe dépasse légèrement de la face supérieure 26 du bloc élastomère de telle façon que, lorsque le cylindre intérieur 30 est en position basse, il reste une partie saillante qui écarte le support de la face supérieure du bloc d'une distance égale à environ le tiers de la hauteur du composant le plus mince, ainsi qu'il a été expliqué ci-dessus à propos du mode de réalisation représenté sur les figures 1, 2 et 3. Ce système de canon à ressort est utilisable dans tous les modes de réalisation de l'invention, notamment lorsque les supports ou substrats 14 sont positionnés à la main sur le dispositif.

La figure 7, enfin, représente un mode de réalisation particulier d'un chargeur tubulaire 12 et illustre la possibilité d'épouser la forme des composants avec des parois minces. Le composant 36 vu par transparence est un transistor miniature. De tels chargeurs permettent de disposer les composants pratiquement aussi près l'un de l'autre qu'on peut le souhaiter.

**Revendications**

1. Procédé d'assemblage d'une pluralité de composants électroniques (19) sur une face d'un support (14) muni de métallisations, procédé dans lequel on utilise des chargeurs (12) tubulaires pourvus d'un orifice supérieur et d'un orifice inférieur, renfermant chacun une pile de composants et disposés selon une configuration identique à celle désirée pour les composants sur le support et dans lequel, à la suite du positionnement des métallisations dudit support en correspondance avec les orifices supérieurs (24) des chargeurs, on fait monter les composants de chaque chargeur de telle façon que le composant du haut arrive en butée contre le support (14), caractérisé en ce qu'on réunit l'orifice inférieur (16) de chaque chargeur tubulaire à une source de fluide et qu'on réalise la montée des composants au moyen d'une surpression dudit fluide.

2. Procédé selon la revendication 1, caractérisé en ce qu'on applique simultanément la surpression à tous les chargeurs tubulaires (12).

3. Dispositif pour la mise en œuvre du procédé selon la revendication 2, comportant des chargeurs tubulaires (12) contenant chacun une pile de composants (19) soutenus par un élément coulissant (20, 21), caractérisé en ce qu'il comporte également un capot étanche (23) alimenté en gaz comprimé, capot dans lequel débouchent les orifices (16) inférieurs des chargeurs.

4. Dispositif selon la revendication 3, caractérisé en ce que les chargeurs (12) possèdent des parois dont la section transversale épouse la forme des composants que le chargeur contient.

5. Dispositif selon l'une des revendications 3 ou 4, caractérisé en ce qu'il comporte une platine supérieure (13) qui constitue le couvercle du capot étanche, qui est percée de trous disposés selon une configuration identique à celle désirée pour les composants sur le support, trous au travers desquels débouchent les orifices supérieurs (24) des chargeurs contenus dans le capot, et qui est pourvue de moyens (11, 15) pour positionner les métallisations du support en correspondance avec les orifices supérieurs (24) des chargeurs.

6. Dispositif selon la revendication 5, caractérisé en ce qu'il comporte un plateu (17) coulissant dans le capot (23) pour extraire les chargeurs au travers de la platine.

7. Dispositif selon l'une des revendications 3 ou 4, caractérisé en ce que le capot étanche (23) est surmonté par un bloc de matériau élastomère (25) qui constitue le couvercle du capot, maintient les chargeurs (12) disposés selon une configuration identique à celle désirée pour les composants sur le support, et est pourvu de moyens (11, 28) pour positionner les métallisations du support en correspondance avec les orifices supérieurs des chargeurs.

8. Dispositif selon l'une quelconque des revendications 3 à 7, caractérisé en ce que les moyens de positionnement des métallisations en correspondance avec des points appropriés du support comprennent des éléments (28) comportant des pièces (30) mues par une force élastique d'une position basse vers une position haute, éléments dont une partie (29) reste légèrement saillante lorsque lesdites pièces sont en position basse.

**Patentansprüche**

1. Verfahren zum Montieren einer Anzahl elektronischer Bauelemente (19) auf einer Seite einer mit Leiterbahnen versehenen Unterlage (14), wobei rohrförmige Magazine (12) mit einer oberen und einer unteren Öffnung verwendet werden, die je einen Stapel Bauelemente enthalten und in einem Muster angeordnet sind, das dem gewünschten Muster der Bauelemente auf der Unterlage entspricht und wobei nach Ausrichtung der Leiterbahnen der genannten Unterlage entsprechend den oberen Öffnungen (24) der Magazine, die Bauelemente jedes Magazins derart hochgedrückt werden, dass das oberste Bauelement an der Unterlage liegt, dadurch gekennzeichnet, dass die untere Öffnung (16) jedes rohrförmige Magazin mit einer Fluidquelle verbunden wird und das Hochdrücken der Bauelemente durch überdruckt des genannten Fluids erfolgt.

2. Verfahren nach Anspruch 1, dadurch gekennzeichnet, dass alle rohrförmigen Magazine (12) gleichzeitig einem Überdruck ausgesetzt werden.

3. Vorrichtung zum Durchführen des Verfahrens nach Anspruch 2, mit rohrförmigen Magazinen (12) mit je einem Stapel Bauelemente (19), die durch ein Schiebeelement (20, 21) unterstützt werden, dadurch gekennzeichnet, dass die Vorrichtung über die ganze Oberfläche eine gasdichte Haube (23) aufweist, welcher ein Gas unter Druck zugeführt wird und in welche die unteren Öffnungen (16) der Magazine münden.

4. Vorrichtung nach Anspruch 3, dadurch gekennzeichnet, dass die Magazine (12) Wände aufweisen, deren Querschnitt die Form der in dem Magazin vorhandenen Bauelemente aufweist.

5. Vorrichtung nach einem der Ansprüche 3 oder 4, dadurch gekennzeichnet, dass sie eine Oberplatte (13) aufweist, die den Deckel der gasdichten Haube bildet, die Löcher aufweist welche angeordnet sind entsprechend dem gewünschten Muster der Bauelemente auf der Unterlage, durch welche Löcher die oberen Öffnungen (24) der Magazine in der Haube ragen, und die mit Mitteln (11, 15) versehen ist, um die Leiterbahnen der Unterlage gegenüber den oberen Öffnungen (24) der Magazine auszurichten.

6. Vorrichtung nach Anspruch 5, dadurch gekennzeichnet, dass sie eine Platte (17) aufweist, die in der Haube (23) verschiebbar ist, um die Magazine über die Oberplatte (13) herauszudrücken.

7. Vorrichtung nach einem der Ansprüche 3 oder 4, dadurch gekennzeichnet, dass die gasdichte Haube (23) von einem Block (25) aus einem Elastomer überlagert ist, der den Deckel der Haube bildet und die Magazine (12) enthält, die in einem Muster angeordnet sind, das dem gewünschten Muster der Bauelemente auf der Unterlage entspricht und der mit Mitteln (11, 28) versehen ist um die Leiterbahnen der Unterlage gegenüber den oberen Öffnungen der Magazine auszurichten.

8. Vorrichtung nach einem der Ansprüche 3 bis 7, dadurch gekennzeichnet, dass die Mittel zum Ausrichten der Leiterbahnen gegenüber den zugeordneten Stellen der Unterlage Elemente (28) enthalten mit Teilen (30), die durch Federkraft aus einer unteren in eine obere Lage bewegbar sind und mit Teilen (29), die etwas herausragen, wenn die Teile (30) sich in der unteren Lage befinden.

**Claims**

1. A process for assembling a plurality of electronic components (19) on a surface of a substrate (14) comprising metallizations process utilizing tubular magazines (12) which comprise an upper opening and a lower opening and each of which contains a stack of components, said magazines being arranged in a pattern which is identical to that desired for the components on the substrate and, after the positioning of the metallizations of said substrate so that they correspond to the upper openings (24) of the magazines, the components in each magazine being lifted so that the uppermost component comes to rest against the substrate (14), characterized in that the lower opening (16) of each tubular magazine is connected to a source of luid, the lifting of the components being effected by means of an overpressure of said fluid.

2. A process as claimed in claim 1, characterized in that the overpressure is simultaneously applied to all the tubular magazines (12).

3. A device for performing the process claimed in claim 2, comprising tubular magazines (12), each of which contains a stack of components (19) which are supported by a sliding member (20, 21), characterized in that the device also comprises a gas-tight housing (23) which receives a compressed gas and into which the lower openings (16) of the magazine open.

4. A device as claimed in claim 3, characterized in that the magazines (12) comprise walls, whose transverse section corresponds to the shape of the components contained in the magazine.

5. A device as claimed in one of the claims 3 or 4, characterized in that it comprises an upper plate (13) which constitutes the lid of the gas-tight housing and which comprises holes arranged in a pattern which is identical to that desired for the components on the substrate, the upper openings (24) of the magazines contained in the housing passing through said holes, and said plate comprising means (11, 15) for positioning the metallizations of the substrate so that they correspond to the upper openings (24) of the magazines.

6. A device as claimed in claim 5, characterized in that it comprises a platform (17) which slides within the housing (23) in order to displace the magazines through the plate for extraction from the housing.

7. A device as claimed in one of the claims 3 or 4, characterized in that on the gas-tight housing (23) there is mounted a block (25) of an elastomeric material which constitutes the lid of the housing, which supports the magazines (12) arranged in a pattern which is identical to that desired for the components on the substrate, and which comprises means (11, 28) for positioning the metallizations of the substrate so that they correspond to the upper openings of the magazines.

8. A device as claimed in any of claims 3 to 7, characterized in that the means for positioning the metallizations such that they correspond to relevant points of the substrate comprise elements (28) provided with portions (30) which are moved by a spring force from a lower position to an upper position, a part (29) of said elements projecting slightly when said portions are in the lower position.

FIG.1

FIG.2

FIG.3    FIG.4

FIG.5

FIG.6

FIG.7